# DEMANDE DE BREVET EUROPEEN

(11) **EP 1 355 317 A1**
(43) Date de publication de la demande: **22.10.2003**
(21) Numéro de dépôt: 02405314.2
(22) Date de dépôt: 18.04.2002
(51) Int. Cl.: G11C 11/404

(54) **Dispositif de rafraichissement d'une memoire**

(71) Demandeur: Newco (Société en formation), 2525 Le Landeron (CH); Ecole Polytechnique Fédérale de Lausanne (EPFL), 1015 Lausanne (CH)
(72) Inventeur: Fazan, Pierre, 2525 Le Landeron (CH); Okhonin, Serguei, 1005 Lausanne (CH)
(74) Mandataire: Gresset, Jean

(57) **Abrégé**

L'invention concerne un dispositif de rafraîchissement d'un ensemble de cellules (10) susceptibles d'occuper l'un ou l'autre de deux états (« 0 », « 1 ») évoluant l'un vers l'autre en fonction du temps, caractérisé en ce qu'il comporte des moyens (22) pour agir simultanément sur toutes les cellules (10) par application d'un même signal de rafraîchissement ayant un effet différencié selon l'état de chaque cellule.

## Description

La présente invention concerne un dispositif de rafraîchissement, notamment d'une mémoire dans laquelle sont enregistrées des informations, généralement sous forme binaire.

L'invention s'applique tout particulièrement, mais non exclusivement, au rafraîchissement d'une mémoire électronique formée sur un substrat semi-conducteur muni de composants dans lesquels une charge électrique peut être stockée. Il peut s'agir, par exemple, d'une mémoire connue sous le nom de DRAM (de l'anglais « Dynamic Random Access Memory »), dont une réalisation fait l'objet de la demande de brevet EP 01810587.4.

Une telle mémoire comporte un circuit de commande et des cellules disposées dans une structure matricielle, chaque cellule étant formée d'un transistor à effet de champ, lequel comporte, de manière classique, un drain, une source, une grille, et un corps compris entre la source et le drain, fréquemment appelé du terme anglais de « body ». Un film diélectrique est interposé entre la grille et le corps. Le drain, la source et la grille forment les bornes du transistor. Selon les potentiels appliqués à ces bornes, une partie du corps, adjacente au film diélectrique et appelée canal, devient électriquement conductrice, permettant la mobilité de charges entre la source et le drain.

Comme expliqué dans la demande de brevet mentionnée ci-dessus, il est possible de stocker, dans le corps, une charge électrique formée de particules chargées (électrons ou trous). De manière classique pour une mémoire binaire de type DRAM, chaque cellule peut prendre les états « 0 » et « 1 » en fonction de la charge stockée. L'état « 1 » correspond à la présence, dans le corps, d'une charge électrique d'une première polarité, alors que l'état « 0 » correspond à l'absence de cette charge ou à une charge de polarité inverse. Les particules chargées sont introduites ou extraites au moyen d'impulsions appliquées aux bornes des transistors par le circuit de commande.

Ainsi qu'il est bien connu, la charge stockée dans ces cellules, tant de l'une que de l'autre polarité, a tendance à décroître dans le temps. Pour éviter de perdre des informations, il est donc nécessaire de compenser la diminution de la charge par une opération dite de rafraîchissement. Dans les dispositifs connus, cette opération est effectuée en balayant les unes après les autres les lignes de la matrice constituant la mémoire. A chaque fois, l'information contenue dans chacune des cellules est lue, puis réécrite de la même manière qu'a été créée la charge initiale.

Dans les mémoires à forte capacité, une part importante du temps est inévitablement utilisée pour effectuer l'opération. En effet, lorsque la capacité de la mémoire DRAM atteint 1 Gb, celle-ci comporte généralement 2²⁰, soit 1'048'576 lignes. Comme le temps nécessaire pour le rafraîchissement de chaque ligne dépasse 10 ns, il faut plus de 10 ms pour assurer un rafraîchissement complet de la mémoire. Or, de manière typique, le rafraîchissement de l'information doit s'effectuer toutes les 10 à 100 ms.

La présente invention a pour but fournir une technique de rafraîchissement des cellules d'une mémoire, qui nécessite un minimum de temps et utilise des moyens de commande simples.

De façon plus précise, l'invention concerne un dispositif de rafraîchissement d'un ensemble de cellules susceptibles d'occuper l'un ou l'autre de deux états évoluant l'un vers l'autre en fonction du temps, caractérisé en ce qu'il comporte des moyens pour agir simultanément sur toutes les cellules par application d'un même signal de rafraîchissement ayant un effet différentié selon l'état de chaque cellule.

Lorsqu'un tel dispositif sert au rafraîchissement d'un ensemble de cellules électroniques binaires ayant des états définis par l'une ou l'autre de deux charges électriques formées de particules dont les nombres tendent à s'égaliser en fonction du temps, le signal de rafraîchissement est avantageusement constitué d'impulsions aptes à créer, dans les cellules, des particules dont le nombre permet de compenser la tendance à l'égalisation des charges.

L'invention s'applique tout particulièrement au cas où les cellules à rafraîchir comportent chacune un transistor à effet de champ comprenant une source, un drain, un corps interposé entre la source et le drain, une grille jouxtant le corps et un film diélectrique interposé entre la grille et le corps, lequel est à même de stocker ladite charge, l'application sur la grille d'une tension électrique supérieure à une valeur de seuil, fonction de la charge stockée dans le corps, formant un canal dans ledit corps. Le rafraîchissement est alors réalisé en appliquant, sur les grilles des transistors, une tension comprise entre les valeurs de seuil correspondant à la présence de l'une ou l'autre des deux charges et, sur les sources et les drains, des tensions telles que, en présence d'un canal dans le corps, celui-ci soit parcouru par un courant créant, par ionisation par impact à l'intérieur dudit corps, des particules renforçant la charge qui y est stockée.

La présente invention concerne également une mémoire électronique à semi-conducteur, caractérisée en ce qu'elle comporte un substrat muni d'une couche isolante et, formés sur celle-ci :
- un ensemble de transistors à effet de champ disposés selon une structure matricielle constituée de plusieurs lignes et de plusieurs colonnes et comprenant une source, un drain, un corps interposé entre la source et le drain, une grille jouxtant le corps et un film diélectrique interposé entre la grille et le corps, chacun de ces transistors étant susceptible de stocker dans son corps une charge électrique constituée de particules de l'une des deux polarités et pouvant occuper l'un ou l'autre de deux états déterminés par la présence ou l'absence de cette charge,
- un premier ensemble de pistes conductrices reliant les grilles des transistors d'une même ligne,
- un deuxième ensemble de pistes conductrices reliant les drains des transistors d'une même colonne,
- un circuit de balayage des lignes relié aux pistes du premier ensemble,
- des circuits d'écriture et des circuits de lecture reliés chacun à l'une des pistes du deuxième ensemble, et
- un circuit de rafraîchissement relié au circuit de balayage et aux circuits d'écriture pour appliquer simultanément à tous les transistors un même signal de rafraîchissement ayant un effet différencié selon l'état de chaque transistor.

Lorsque, pour chaque transistor, un canal électriquement conducteur peut être formé, dans ledit corps, entre la source et le drain par application d'un potentiel électrique sur la grille, ledit canal se formant lorsque le potentiel appliqué atteint une valeur supérieure à une valeur seuil, fonction de la charge que comporte le corps, le circuit de rafraîchissement a pour fonction d'appliquer sur les grilles des transistors un potentiel définissant une tension comprise entre les tensions de seuil, de manière à ce que ledit canal soit formé seulement dans les transistors porteurs de l'un desdits types de charges.

Dans ce cas, le circuit de rafraîchissement a avantageusement pour fonction d'appliquer sur les sources et les drains de chacun des transistors des potentiels tels que, en présence d'un canal dans le corps, celui-ci soit parcouru par un courant créant, par ionisation par impact à l'intérieur dudit corps, des particules renforçant la charge qui y est stockée.

D'autres caractéristiques de l'invention ressortiront de la description qui va suivre, faite en regard du dessin annexé, dans lequel:
- les figures 1 et 2 représentent une portion de mémoire et ses circuits de commande dont les informations sont rafraîchies respectivement par un procédé connu, et par le procédé selon l'invention,
- la figure 3 illustre un exemple de trains d'impulsions pouvant être appliqués aux cellules pour atteindre le but recherché, et
- la 4 figure montre comment varie, en fonction du temps, la charge d'une cellule selon qu'est stockée une charge correspondant à un état « 1 » ou à l'état « 0 ».

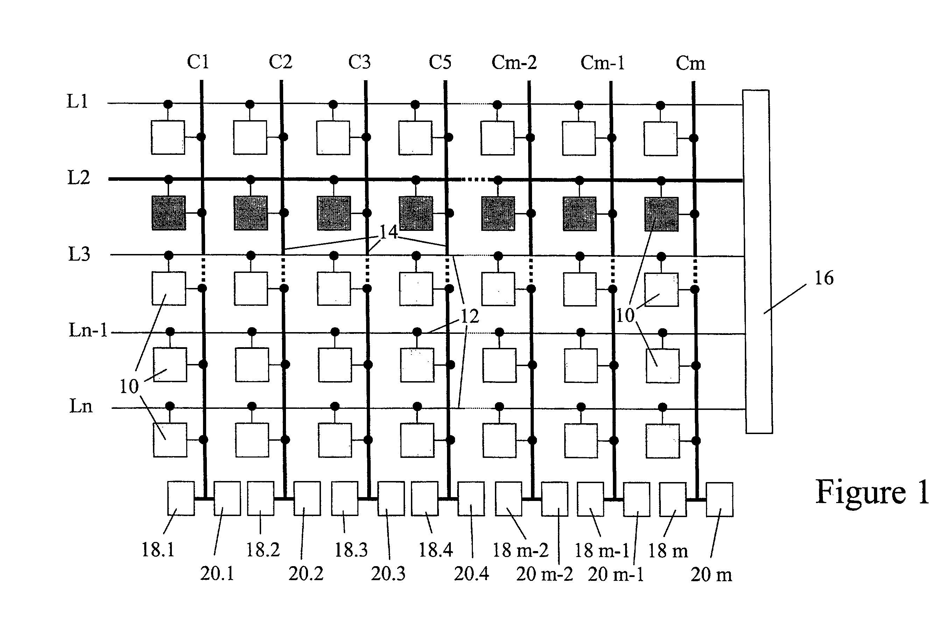

Pour bien comprendre la différence entre le procédé de rafraîchissement connu et le procédé appliqué au moyen du dispositif selon l'invention, la figure 1 montre une portion de mémoire de type DRAM, présentant une structure matricielle comportant m colonnes et n lignes avec, en chaque point de la matrice, une cellule mémoire 10 formée d'un transistor NMOS SOI.

Les transistors comprennent, de manière classique mais non représentée sur le dessin, une source, un drain et un corps interposé entre la source et le drain, un film diélectrique recouvrant le corps et débordant sur la source et le drain ainsi qu'une grille recouvrant ce film. L'application sur la grille d'une tension critique, supérieure à une valeur de seuil, permet de créer, à l'interface du corps et du film, un canal électriquement conducteur.

Pour chacun des transistors formant les cellules 10, leur source est à la masse, leur grille est reliée à une piste conductrice 12, chacune associée à l'une des lignes de la matrice, alors que leur drain est relié à une piste conductrice 14, chacune associée à l'une des colonnes.

Dans cette mémoire, l'enregistrement d'informations se fait selon le principe décrit dans la demande de brevet EP 01810587.4 déjà citée. Cette fonction, qui ne sera pas décrite de manière plus détaillée ci-après, permet de mémoriser une information de type binaire, soit un « 0 » ou un « 1 », sous forme d'une charge électrique formée de particules chargées (des trous lorsqu'il s'agit de transistors de type NMOS) stockée ou non dans le corps du transistor. Comme ce corps se trouve dans un environnement qui n'est pas parfaitement isolant, il en résulte que le niveau de la charge diminue par migration des particules qui la constituent. Il est donc nécessaire d'effectuer un rafraîchissement de l'information mise en mémoire.

Pour assurer cette fonction, la mémoire comporte un circuit de sélection 16, agencé pour balayer séquentiellement les lignes de la matrice, et des circuits d'écriture 18ᵢ et de lecture 20ᵢ, i variant de 1 à m, à raison d'un circuit de lecture et d'un circuit d'écriture par colonne. Dans certains dispositifs, les deux fonctions de lecture et d'écriture peuvent être assurées par un même circuit.

Un cycle de rafraîchissement comporte un balayage complet des lignes 1 à n de la matrice, ces lignes étant successivement sélectionnées par le circuit 16. Sur la figure 1, c'est la ligne 2 qui est représentée comme étant rafraîchie. A chacune des lignes balayées, le circuit de lecture 20ᵢ de chacune des colonnes 1 à n détermine la présence ou non de la charge différenciant l'état « 1 » de l'état « 0 ». Selon l'information récoltée, il donne l'ordre au circuit 18ᵢ auquel il est associé de réécrire cette information.

Ainsi, pour assurer le rafraîchissement d'une mémoire de 1 Gb, qui comporte généralement 1'048'576 lignes, lorsqu'on utilise la technique actuelle, il faut 10 à 50 ms, à raison de 10 à 50 ns par ligne. Dès lors que le rafraîchissement doit être effectué une dizaine de fois par seconde, il apparaît que le temps nécessaire au rafraîchissement est du même ordre de grandeur que celui restant pour la lecture et l'écriture. Ainsi, le temps consacré au rafraîchissement limite la capacité des mémoires et nécessite des précautions particulières pour réduire les courants de fuites.

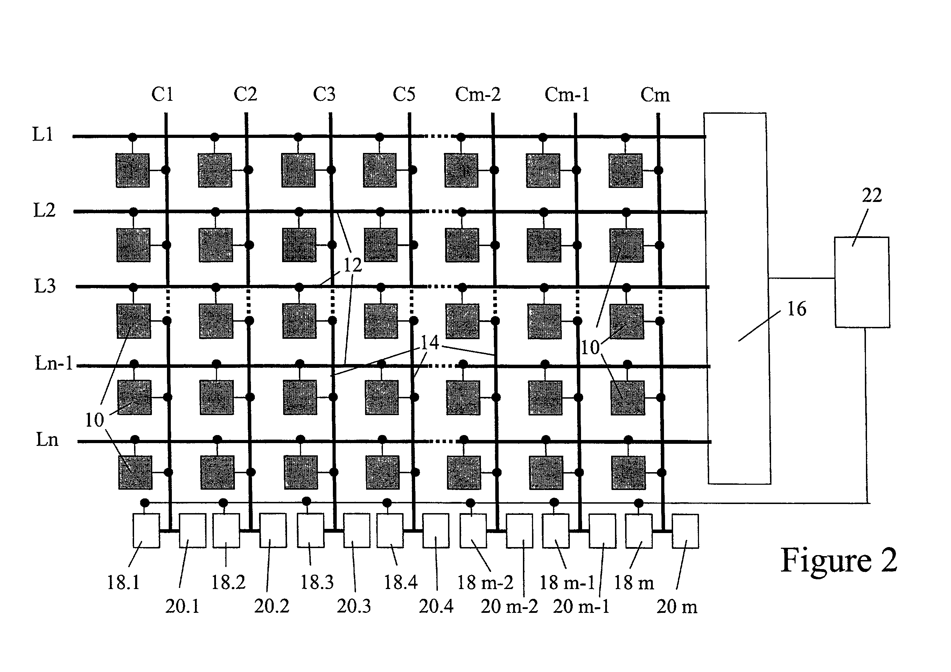

La mémoire représentée à la figure 2 comporte également des cellules 10 formées chacune d'un transistor de type NMOS SOI, des pistes 12 et 14, un circuit de sélection 16 et des circuits d'écriture 18ᵢ et de lecture 20ᵢ. Elle comporte, en outre, comme dispositif de rafraîchissement, un circuit 22 relié à toutes les lignes 1 à n par le circuit 16, et à toutes les colonnes 1 à m par les circuits d'écriture 18ᵢ.

Dans cette mémoire, l'écriture et la lecture se font de la même manière que dans les dispositifs connus et donc dans celui décrit en référence à la figure 1. Ces deux fonctions ne seront donc pas décrites de manière plus détaillée.

L'opération de rafraîchissement est effectuée, par contre, de manière beaucoup plus simple et rapide.

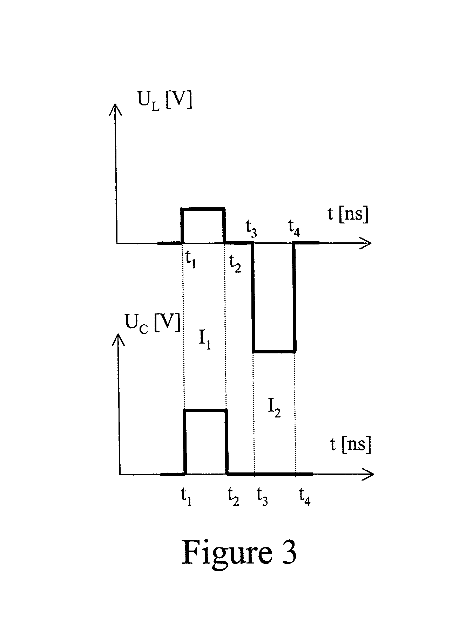

En effet, chaque fois que le contenu de la mémoire doit être rafraîchi, le circuit 22 donne aux circuits 16 et 18ᵢ, l'ordre d'appliquer à toutes les lignes, respectivement toutes les colonnes, deux impulsions successives l₁ et l₂, telles que représentées sur la figure 3.

De manière plus précise, l'impulsion l₁, qui débute au temps t₁ et se termine au temps t₂, et dont la durée est de quelques nanosecondes, est obtenue en appliquant un potentiel de + 0,6V aux lignes et un potentiel de + 1,2V aux colonnes. L'impulsion l₂, qui débute au temps t₃ et se termine au temps t₄, de quelques nanosecondes également, est obtenue en appliquant aux lignes un potentiel de - 2V, alors que les colonnes sont à la masse. On relèvera que t₂ et t₃ peuvent être, ou non, confondus.

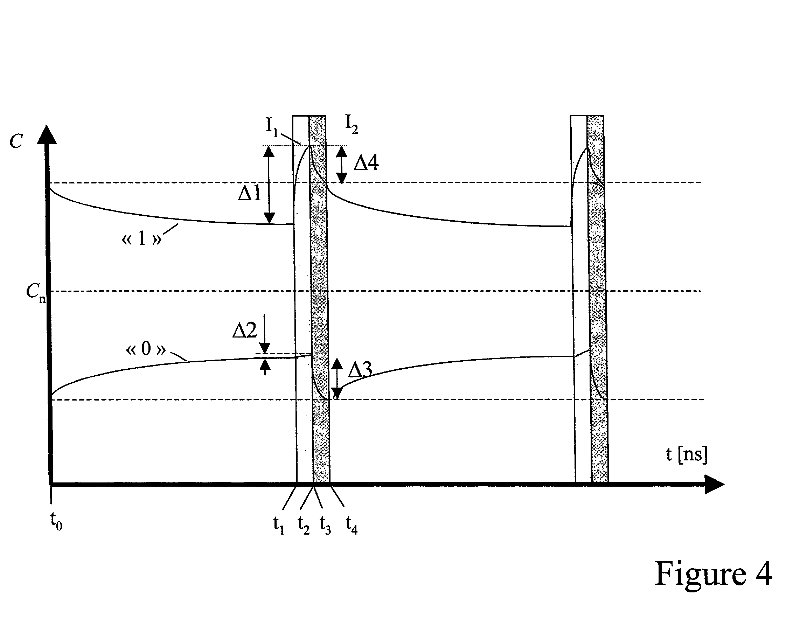

La figure 4 montre comment varient, au cours du temps, les charges C des cellules 10. Les courbes supérieure et inférieure correspondent respectivement à des cellules de type « 1 » et de type « 0 », alors que la ligne médiane indique le niveau de charge Cₙ vers lequel tendent les cellules lorsque leur état n'est pas rafraîchi.

A l'instant t₀ qui correspond à un état initial, les cellules 10, comportant ou non une charge formée de trous, présentent une charge supérieure (pour l'état « 1 ») ou inférieure (pour l'état « 0 ») au niveau de charge Cₙ. Au cours du temps, la différence entre ces deux niveaux de charge décroît de manière sensiblement logarithmique.

Au temps t₁ débute l'impulsion l₁, engendrant un courant important dans les cellules de type « 1 », alors qu'il est pratiquement négligeable dans les cellules de type « 0 ». Cela est dû au fait que la tension de seuil des cellules de type « 1 » est inférieure à celle des cellules de type « 0 ». Le potentiel de + 0,6 V appliqué sur la grille crée un canal à l'interface du corps et du film isolant dans les cellules de type « 1 », et non dans les cellules de type « 0 ». Le courant créé dans le canal génère dans le corps, au voisinage du drain, par ionisation par impact, des trous et des électrons, les trous étant stockés dans le corps alors que les électrons sont éliminés par le drain. De la sorte, la charge croît d'une valeur Δ1 dans les cellules de type « 1 », et d'une valeur Δ2 dans les cellules de type « 0 », Δ1 étant deux à trois ordres de grandeur supérieur à Δ2. De plus, des électrons sont piégés dans des défauts structurels que comporte le corps à son interface avec le film diélectrique, aussi bien dans les cellules de type « 0 » que de type « 1 ».

Au temps t₃, ici confondu avec t₂, débute la deuxième impulsion l₂ qui fait décroître la charge dans les deux types de cellules. Le potentiel de - 2 V appliqué aux lignes, et en conséquence aux grilles des transistors, attire les trous à l'interface du corps et du film diélectrique, qui se recombinent avec les électrons piégés, restaurant ainsi la charge des « 0 », laquelle varie de Δ3 et réduisant de Δ4 la charge dans les cellules de type « 1 ». Δ3 et Δ4 sont égaux. Ce processus est donc le même dans les cellules de type « 1 » et de type « 0 ».

Au temps t₄, les charges des cellules des deux types ont retrouvé leur état initial. Ainsi, grâce au fait que l'impulsion l₁ n'a pas le même effet sur les cellules de type « 0 » et sur celles de type « 1 », il est possible de rafraîchir une mémoire, ou tout au moins plusieurs lignes à la fois, sans devoir au préalable lire l'état de chacune des cellules.

Une telle solution permet d'accélérer d'environ mille fois le processus de rafraîchissement. On peut ainsi utiliser des transistors présentant des caractéristiques techniques moins difficiles à atteindre, et plus spécialement des temps de rétention plus faibles, dont le coût est, en conséquence, moins élevé.

Dans le processus décrit ci dessus, seul le premier signal permet de renforcer la différenciation, par une action beaucoup plus importante sur les cellules de type « 1 » que sur celles de type « 0 ». Il va de soi que, par un choix d'autres signaux, engendrant d'autres phénomènes physiques, il est possible d'atteindre le même but en agissant sur les cellules de l'un et/ou l'autre des types « 0 » et « 1 ».

On relèvera que le résultat est le même si l'on inverse l'ordre dans lequel les impulsions l₁ et l₂ sont appliquées.

La solution décrite fait appel à des transistors de type NMOS. Mais il est évident que le même principe est applicable aux transistors PMOS, la polarité des tensions appliquées étant alors inversée.

Le mode de réalisation de l'invention décrit ci-dessus se rapporte à un dispositif semi-conducteur du type mémoire DRAM. Il va de soi que le processus de rafraîchissement tel que décrit, c'est à dire mettant en oeuvre des signaux ayant un effet différent sur les cellules, selon qu'elles sont dans un premier ou un second état, et renforçant leur différenciation, peut être appliqué à d'autres types de dispositifs, semi-conducteurs ou non, sans pour autant sortir du cadre de l'invention.

## Revendications

1. Dispositif de rafraîchissement d'un ensemble de cellules (10) susceptibles d'occuper l'un ou l'autre de deux états (« 0 », « 1 ») évoluant l'un vers l'autre en fonction du temps, **caractérisé en ce qu'**il comporte des moyens (22) pour agir simultanément sur toutes les cellules (10) par application d'un même signal de rafraîchissement ayant un effet différencié selon l'état de chaque cellule.

2. Dispositif selon la revendication 1, pour le rafraîchissement d'un ensemble de cellules électroniques binaires (10) ayant des états définis (« 0 », « 1 ») par l'une ou l'autre de deux charges électriques formées de particules dont les nombres tendent à s'égaliser en fonction du temps, **caractérisé en ce que** le signal de rafraîchissement est constitué d'impulsions aptes à créer, dans les cellules, des particules dont le nombre permet de compenser la tendance à l'égalisation des charges.

3. Dispositif selon la revendication 2, pour le rafraîchissement d'un ensemble de cellules comportant chacune un transistor (10) à effet de champ comprenant une source, un drain, un corps interposé entre la source et le drain, une grille jouxtant le corps et un film diélectrique interposé entre la grille et le corps, lequel est à même de stocker ladite charge, l'application sur la grille d'une tension électrique supérieure à une valeur de seuil, fonction de la charge stockée dans le corps, formant un canal dans ledit corps, **caractérisé en ce que** lesdits moyens (22) ont pour fonction d'appliquer, sur les grilles des transistors, une tension comprise entre les valeurs de seuil correspondant à la présence de l'une ou l'autre des deux charges et, sur les sources et les drains, des tensions telles que, en présence d'un canal dans le corps, celui-ci soit parcouru par un courant créant, par ionisation par impact à l'intérieur dudit corps, des particules renforçant la charge qui y est stockée.

4. Mémoire électronique à semi-conducteur, **caractérisée en ce qu'**elle comporte un substrat muni d'une couche isolante et, formés sur celle-ci :
- un ensemble de transistors à effet de champ disposés selon une structure matricielle constituée de plusieurs lignes (Lⱼ) et de plusieurs colonnes (Cᵢ) et comprenant une source, un drain, un corps interposé entre la source et le drain, une grille jouxtant le corps et un film diélectrique interposé entre la grille et le corps, chacun de ces transistors étant susceptible de stocker dans son corps une charge électrique constituée de particules de l'une des deux polarités et pouvant occuper l'un ou l'autre de deux états déterminés par la présence ou l'absence de cette charge,
- un premier ensemble de pistes conductrices (12) reliant les grilles des transistors d'une même ligne (Lⱼ),
- un deuxième ensemble de pistes conductrices (14) reliant les drains des transistors d'une même colonne (Cᵢ),
- un circuit de balayage des lignes (16) relié aux pistes du premier ensemble,
- des circuits d'écriture (18ᵢ) et des circuits de lecture (20ᵢ) reliés chacun à l'une des pistes (14) du deuxième ensemble (Cᵢ), et
- un circuit de rafraîchissement (22) relié au circuit de balayage (16) et aux circuits d'écriture (18ᵢ) pour appliquer simultanément à tous les transistors un même signal de rafraîchissement ayant un effet différencié selon l'état de chaque transistor.

5. Mémoire selon la revendication 4, dans laquelle, pour chaque transistor, un canal électriquement conducteur peut être formé, dans ledit corps, entre la source et le drain par application d'un potentiel électrique sur la grille, ledit canal se formant lorsque le potentiel appliqué atteint une valeur supérieure à une valeur seuil, fonction de la charge que comporte le corps, **caractérisée en ce que** ledit circuit de rafraîchissement a pour fonction d'appliquer sur les grilles des transistors un potentiel définissant une tension comprise entre les tensions de seuil, de manière à ce que ledit canal soit formé seulement dans les transistors porteurs de l'un desdits types de charges.

6. Mémoire selon la revendication 5, **caractérisée en ce que** ledit circuit de rafraîchissement a pour fonction d'appliquer sur les sources et les drains de chacun des transistors des potentiels tels que, en présence d'un canal dans le corps, celui-ci soit parcouru par un courant créant, par ionisation par impact à l'intérieur dudit corps, des particules renforçant la charge qui y est stockée.
